# EUROPEAN PATENT APPLICATION

(11) **EP 4 475 179 A1**
(43) Date of publication of application: **11.12.2024**
(21) Application number: 23749526.2
(22) Date of filing: 18.01.2023
(51) Int. Cl.: H01L 23/29, C08F 290/06, C08G 59/40, H01L 23/31

(54) **UNDERFILL MATERIAL**

(30) Priority: 01.02.2022 JP 2022014315
(71) Applicant: AJINOMOTO CO., INC., Chuo-ku Tokyo 104-8315 (JP)
(72) Inventor: OGURA, Ichiro, Kawasaki-shi, Kanagawa 210-0801 (JP); OKAZAKI, Daichi, Kawasaki-shi, Kanagawa 210-0801 (JP)
(74) Representative: Mewburn Ellis LLP
(86) International application number: PCT/JP2023/001363
(87) International publication number: WO 2023/149210

(57) **Abstract**

Provided are an underfill material and so forth that are capable of giving a cured product having a short filling time and a superior crack resistance. The underfill material includes (A) an epoxy resin having two or more epoxy groups per one molecule thereof, (B) a compound having a functional group that is capable of reacting with the epoxy group of the component (A) and an ethylenic unsaturated group, and (C) an inorganic filler.

## Description

### Field

The present invention relates to an underfill material, a cured product of the underfill material, a semiconductor chip package containing the cured product of the underfill material, a method for producing a semiconductor chip package, and a semiconductor device containing the semiconductor chip package.

### Background

There is a growing need for a semiconductor chip package including a circuit board and a semiconductor chip mounted on the circuit board as a smartphone, a tablet PC, and the like become increasingly popular. When a circuit board is bonded with a semiconductor chip, a gap (space) between the circuit board and the semiconductor chip is filled with an insulating material called an underfill material to protect the bonding portion and a wiring area from an external environment and to prevent a defect such as a crack due to a difference in the thermal expansions of the circuit board and of the semiconductor chip.

As for the filling method of the underfill material, there are a pre-application method, in which the underfill material is first applied onto the circuit board and the circuit board is then bonded to the semiconductor chip, and a post-application method (capillary underfill method), in which the gap is filled with the underfill material after the circuit board and the semiconductor chip are bonded.

As for the underfill material that is used in the post-application method, for example, the underfill material containing an epoxy resin and a curing agent is disclosed (see Patent Literature 1).

### Citation List

### Patent Literature

Patent Literature 1: Japanese Patent Application Laid-open No. 2021-075508

### Summary

### Technical Problem

In recent years, in the most advanced semiconductor field, there has been an increasing need for the semiconductor chip package such as a large die package having the size of 900 mm² or more, or a multiple die package having a plurality of dies.

However, in the case where the package is large or has a plurality of dies, there has been a problem in the post-application method that a long filling time is necessary to fill the gap between the circuit board and the semiconductor chip with the underfill material. In addition, because of the large size of the package, the underfill material may be suffered from a failure crack due to a thermal stress.

Thus, the underfill material that is used in the post-application method is required to have flowability to shorten the filling time. In addition, the cured product of the underfill material used for the large die package or for the multiple die package is required to have a superior crack resistance, and to suppress an overhang around the die after filling with the underfill material, i.e., to suppress a so-called fillet area.

The present invention has been devised in view of the aforementioned problems, and thus has an object to provide: an underfill material capable of filling with a short filling time and of producing a cured product that has a superior crack resistance; a cured product of the underfill material; a semiconductor chip package containing the cured product of the underfill material; a semiconductor device having a semiconductor chip package; and a method for producing the semiconductor chip package. Solution to Problem

The inventors of the present invention have carried out an extensive investigation, and as a result, found that the underfill material having the following configuration can solve the aforementioned problems, and completed the present invention based of this finding.

Namely, the present invention includes following contents.
[1]. An underfill material comprising:
   (A) an epoxy resin having two or more epoxy groups per one molecule thereof,
   (B) a compound having a functional group that is capable of reacting with the epoxy group of the component (A) and an ethylenic unsaturated group, and
   (C) an inorganic filler.
[2]. The underfill material according to [1], further comprising (D) a compound having an ethylenic unsaturated group not containing a functional group capable of reacting with the component (A).
[3]. The underfill material according to [2], wherein a content of the component (D) is 10% by mass or more to 70% by mass or less relative to 100% by mass of resin components in the underfill material.
[4]. The underfill material according to any one of [1] to [3], wherein a content of the component (C) is 60% by mass or more relative to 100% by mass of components in the underfill material.
[5]. The underfill material according to any one of [1] to [4], wherein a viscosity of the underfill material at 40°C is 2000 mPa·s or less.
[6]. The underfill material according to any one of [1] to [5], wherein a molar ratio of all epoxy groups in the component (A) to all functional groups in the component (B) (all epoxy groups in the component (A) : all functional groups in the component (B)) is in the range of 30:70 to 80:20.
[7]. The underfill material according to any one of [1] to [6], wherein the functional group of the component (B) that is capable of reacting with the epoxy group of the component (A) is one or more groups selected from an epoxy group, an acid anhydride group, and a carboxyl group.
[8]. The underfill material according to any one of [1] to [7], wherein the component (B) comprises a compound having one or more epoxy groups and one or more ethylenic unsaturated groups in one molecule thereof.
[9]. The underfill material according to any one of [1] to [8], wherein the component (B) comprises a glycidyl (meth)acrylate.
[10]. The underfill material according to any one of [1] to [9], wherein the underfill material further comprises (E) a radical polymerization catalyst.
[11]. The underfill material according to any one of [1] to [10], wherein the underfill material further comprises (F) an organic base.
[12]. The underfill material according to any one of [1] to [11], wherein the underfill material further comprises (G) an organic filler.
[13]. The underfill material according to any one of [1] to [12], wherein an average particle diameter of the component (C) is 15 um or less.
[14]. The underfill material according to any one of [1] to [13], wherein an elastic modulus at 250°C of a cured product obtained by curing the underfill material is 1.0 GPa or more.
[15]. The underfill material according to any one of [1] to [14], wherein a cure shrinkage of a cured product obtained by curing the underfill material is 1% or more.
[16]. The underfill material according to any one of [1] to [15], wherein the underfill material is used to fill a gap between a circuit board and a semiconductor chip.
[17]. The underfill material according to any one of [1] to [16], wherein the underfill material is used to fill a gap between a semiconductor chip and a rewiring layer.
[18]. The underfill material according to any one of [1] to [17], wherein the underfill material is used to fill a gap between a circuit board and a rewiring layer.
[19]. The underfill material according to [17] or [18], wherein the rewiring layer comprises polyimide.
[20]. The underfill material according to any one of [1] to [19], wherein the underfill material is for a semiconductor device of a multiple die package.
[21]. The underfill material according to any one of [1] to [20], wherein the underfill material is for a semiconductor device of a semiconductor chip package having an area of 900 mm² or more.
[22]. The underfill material according to any one of [1] to [21], wherein the underfill material is for a semiconductor device comprising a fan-out type package.
[23]. The underfill material according to any one of [1] to [22], wherein the underfill material is for a semiconductor device comprising a semiconductor package comprising a silicon interposer.
[24]. The underfill material according to any one of [1] to [23], wherein the underfill material is for a semiconductor device comprising a laminate having two or more semiconductor chips laminated in a vertical direction through a through silicon via.
[25]. The underfill material according to any one of [16] to [18], wherein the gap is 200 um or less.
[26]. The underfill material according to any one of [16] to [18], wherein the gap is 100 um or less.
[27]. The underfill material according to any one of [1] to [26], wherein the underfill material comprises at least one or more of the component (D) having a viscosity of 50 mPa·s or less at 25°C.
[28]. The underfill material according to any one of [1] to [27], wherein the underfill material comprises at least one or more of the component (B) having a viscosity of 50 mPa·s or less at 25°C.
[29]. The underfill material according to any one of [1] to [28], wherein the underfill material is used in a post-application method.
[30]. A semiconductor chip package comprising a cured product of the underfill material according to any one of [1] to [29].
[31]. A semiconductor chip package comprising a circuit board, a semiconductor chip that is bonded and mounted to the circuit board, and a cured product of the underfill material according to any one of [1] to [29] that fills a gap between the circuit board and the semiconductor chip.
[32]. The semiconductor chip package according to [30] or [31], wherein (S2/S1) × 100 is 120% or less, provided that S1 represents a projected area of a surface of a semiconductor chip and S2 represents a projected area of the cured product of the underfill material.
[33]. The semiconductor chip package according to any one of [30] to [32], wherein (S2/S1) × 100 is 110% or less, provided that S1 represents a projected area of a surface of a semiconductor chip and S2 represents a projected area of the cured product of the underfill material.
[34]. The semiconductor chip package according to any one of [30] to [33], wherein (S2/S1) × 100 is 105% or less, provided that S1 represents a projected area of a surface of a semiconductor chip and S2 represents a projected area of the cured product of the underfill material.
[35]. The semiconductor chip package according to any one of [30] to [34], wherein a cross-sectional shape of the cured product of the underfill material becomes smaller from a semiconductor chip toward a center of the cured product and larger from the center of the cured product toward the circuit board.
[36]. A method for producing a semiconductor chip package, the method comprising a step of filling a gap between a circuit board and a semiconductor chip or an interposer with the underfill material according to any one of [1] to [29], wherein
   an area of the semiconductor chip package or of the interposer is 900 mm² or more, the gap is 600 um or less, and a filling completion time of the underfill material is less than 120 minutes.
[37]. A semiconductor device comprising the semiconductor chip package according to any one of [30] to [36] .
[38]. A cured product of the underfill material according to any one of [1] to [29].

### Advantageous Effects of Invention

According to the present invention, it is possible to provide an underfill material capable of filling with a short filling time and of giving a cured product thereof having a superior crack resistance; a cured product of the underfill material; a semiconductor chip package containing the cured product of the underfill material; a semiconductor device having a semiconductor chip package; and a method for producing the semiconductor chip package.

### Brief Description of Drawings

FIG. 1 is a cross-sectional view and a top view illustrating one example of the semiconductor chip package in the first embodiment of the present invention.
FIG. 2 is a cross-sectional view illustrating one example of the semiconductor chip package in the first embodiment of the present invention.
FIG. 3 is a cross-sectional view illustrating one example of the semiconductor chip package in the second embodiment of the present invention.
FIG. 4 is a cross-sectional view illustrating one example of the semiconductor chip package in the third embodiment of the present invention.
FIG. 5 is a cross-sectional view illustrating one example of the semiconductor chip package in the fourth embodiment of the present invention.
FIG. 6 is a cross-sectional view illustrating one example of the semiconductor chip package in the fifth embodiment of the present invention.
FIG. 7 is a cross-sectional view illustrating one example of the semiconductor chip package in the sixth embodiment of the present invention.

### Description of Embodiments

Hereinafter, the present invention will be described in detail in line with preferable embodiments. However, the present invention is not limited to the following embodiments and examples, and may be implemented with any modification within the scope of the claims of the present invention and the equivalents thereof.

### [Underfill Material]

The underfill material of the present invention contains (A) an epoxy resin having two or more epoxy groups in one molecule thereof, (B) a compound having a functional group that is capable of reacting with the epoxy group of the component (A) and an ethylenic unsaturated group, and (C) an inorganic filler. According to the underfill material described above, the filling time thereof is short due to a low viscosity, and it is possible to obtain its cured product having a superior crack resistance. In addition, the underfill material described above is usually less volatile, which makes it possible to obtain the cured product having superior average coefficient of thermal expansion (CTE) and glass transition temperature (Tg).

The underfill material may further contain optional components, as needed, such as (D) a compound having an ethylenic unsaturated group not containing a carboxyl group, (E) a radical polymerization catalyst, (F) an organic base, (G) an organic filler, (H) another additive, and (I) a solvent. Hereinafter, these components that are contained in the underfill material will be described in detail.

### <(A) Epoxy Resin Having Two or More Epoxy Groups in One Molecule Thereof>

The underfill material contains (A) an epoxy resin having two or more epoxy groups in one molecule thereof as the component (A). There is no particular restriction in the component (A) as long as it is possible to be cured by reacting with the component (B) to be described later. In particular, those that do not contain an ethylenic unsaturated group are preferable as the component (A). The component (A) may be used singly, or in a combination of two or more of these resins.

It is preferable that the component (A) includes an epoxy resin having, in one molecule thereof, two or more epoxy groups, preferably three or more epoxy groups, and more preferably four or more epoxy groups. There is no particular restriction in the upper limit in the number of the epoxy group, and this may be made 10 or less, or the like.

From the viewpoint of clearly obtaining the advantageous effects of the present invention, the component (A) is preferably an epoxy resin that is in the state of liquid at 25°C (hereinafter this is also referred to as "liquid epoxy resin"). Accordingly, in one preferable embodiment, the component (A) is in the state of liquid at 25°C. In the present invention, the term "liquid" as used for the epoxy resin means that the viscosity of the epoxy resin at 25°C is 30000 mPa·s or less, preferably 25000 mPa·s or less, more preferably 20000 mPa·s or less, and still more preferably 15000 mPa·s or less, 10000 mPa·s or less, 8000 mPa·s or less, 6000 mPa·s or less, or 5000 mPa·s or less. A preferable embodiment of the component (A) is the liquid epoxy resin having two or more epoxy groups in one molecule thereof.

Among the liquid epoxy resins, preferable are a bisphenol A type epoxy resin, a bisphenol F type epoxy resin, a bisphenol AF type epoxy resin, a hydrogenated bisphenol A type epoxy resin, a naphthalene type epoxy resin, a glycidyl ester type epoxy resin, a glycidylamine type epoxy resin, a phenol novolac type epoxy resin, an alicyclic epoxy resin having an ester skeleton, a cyclohexane type epoxy resin, a cyclohexanedimethanol type epoxy resin, and an epoxy resin having a butadiene structure; and more preferable are a bisphenol A type epoxy resin, a bisphenol F type epoxy resin, a bisphenol AF type epoxy resin, and a glycidylamine type epoxy resin.

Specifically, illustrative examples of the liquid epoxy resin include "HP4032", "HP4032D", and "HP4032SS" (naphthalene type epoxy resins), manufactured by DIC Corp.; "828US", "828EL", "jER828EL", and "825" (bisphenol A type epoxy resins), manufactured by Mitsubishi Chemical Corp.; "jER807" and "1750" (bisphenol F type epoxy resins), manufactured by Mitsubishi Chemical Corp.; "jER152" (phenol novolac type epoxy resin) manufactured by Mitsubishi Chemical Corp.; "630", "630LSD", and "604" (glycidylamine type epoxy resins), manufactured by Mitsubishi Chemical Corp.; "ED-523T" (glycyrol type epoxy resin) manufactured by ADEKA Corp.; "EP-3950L" and "EP-3980S" (glycidylamine type epoxy resins), manufactured by ADEKA Corp.; "EP-4088S" (dicyclopentadiene type epoxy resin) manufactured by ADEKA Corp.; "ZX1059" (mixture of a bisphenol A type resin and a bisphenol F type epoxy resin) manufactured by Nippon Steel Chemical & Material Co., Ltd.; "EX-721" (glycidyl ether type epoxy resin) manufactured by Nagase ChemteX Corp.; "Celloxide 2021P" (alicyclic epoxy resin having an ester skeleton) manufactured by Daicel Corp.; "PB-3600" manufactured by Daicel Corp., "JP-100" and "JP-200", both manufactured by Nippon Soda Co., Ltd. (all are epoxy resins having a butadiene structure); "ZX1658" and "ZX1658GS" (1,4-glycidylcyclohexane type epoxy resins), manufactured by Nippon Steel Chemical & Material Co., Ltd.; "YX8000" (hydrogenated Bisphenol A type epoxy resin) manufactured by Mitsubishi Chemical Co., Ltd.; and "KF-101" (epoxy-modified silicone resin) manufactured by Shin-Etsu Chemical Co., Ltd.

The epoxy equivalent of the epoxy resin (A) is preferably in the range of 50 g/eq. to 300 g/eq., and the upper limit thereof is more preferably 250 g/eq. or less, and still more preferably 240 g/eq. or less, 220 g/eq. or less, 200 g/eq. or less, or 180 g/eq. or less. The epoxy equivalent is the mass of the resin per one equivalent of the epoxy group. This epoxy equivalent may be measured by the method in accordance with JIS K7236.

From the viewpoint of clearly obtaining the intended effects of the present invention, the weight-average molecular weight (Mw) of the epoxy resin (A) is preferably 100 to 5000, more preferably 250 to 3000, and still more preferably 400 to 1500. The weight-average molecular weight of the resin is the weight-average molecular weight in terms of polystyrene, as measured by a gel permeation chromatography (GPC) method.

From the viewpoint of clearly obtaining the advantageous effects of the present invention, the content of the epoxy resin (A) relative to 100% by mass of resin components in the underfill material is preferably 5% by mass or more, more preferably 10% by mass or more, still more preferably 15% by mass or more, and the upper limit thereof is preferably 60% by mass or less, more preferably 55% by mass or less, and still more preferably 50% by mass or less.

In the present invention, the "resin components" as used in the underfill material refers to the components that constitute the underfill material excluding an inorganic filler to be described later, or in the case where the underfill material contains an organic filler that is the optional component, excluding the inorganic filler and the organic filler.

### <(B) Compound Having a Functional Group Capable of Reacting with the Component (A) and an Ethylenic Unsaturated Group>

The underfill material contains, as the component (B), a compound having a functional group that is capable of reacting with the component (A) and an ethylenic unsaturated group. Inclusion of the component (B) makes it possible not only to lower the viscosity of the underfill material but also to obtain its cured product by reacting with the component (A). The component (B) does not include those that fall under the component (A) described above. The component (B) may be used singly or in a combination of two or more of those described above.

The component (B) has a functional group that is capable of reacting with the component (A). The functional group that is capable of reacting with the component (A) is the group that is capable of reacting with the epoxy group of the component (A), i.e., an epoxy group, an acid anhydride group, a carboxyl group, a hydroxy group, an amino group, an isocyanate group, and the like. Among these, from the viewpoint of clearly obtaining the advantageous effects of the present invention, preferable are one or more groups selected from an epoxy group, an acid anhydride group, a carboxyl group, and a hydroxy group; and more preferable are one or more groups selected from an epoxy group, an acid anhydride group, and a carboxyl group. The number of the functional group that is capable of reacting with the component (A) in one molecule of the compound is preferably one, and this may be two or more in one molecule. In the case where two or more functional groups are present in one molecule, these functional groups that are capable of reacting with the component (A) may be the same or different.

The component (B) has an ethylenic unsaturated group. The ethylenic unsaturated group means those groups that contain an ethylenic carbon-carbon unsaturated bond. The ethylenic unsaturated group is usually a monovalent group, such as a vinyl group, an allyl group, a propargyl group, a butenyl group, an ethynyl group, a phenylethynyl group, a maleimide group, a nadimide group, and a (meth)acryloyl group. Among these, from the viewpoint of clearly obtaining the advantageous effects of the present invention, a (meth)acryloyl group and a vinyl group are preferable, and a (meth)acryloyl group is more preferable. It is preferable to have one or more ethylenic unsaturated groups, and may have a plurality of the ethylenic unsaturated groups, in one molecule. In the case where a plurality of the ethylenic unsaturated groups are present in one molecule, the ethylenic unsaturated groups may be the same or different. The (meth)acryloyl group includes a methacryloyl group, an acryloyl group, and a combination of these.

The concentration of the functional group that is capable of reacting with the component (A) is preferably 0.05 mmol/g or more, more preferably 0.1 mmol/g or more, and preferably 10 mmol/g or less, and more preferably 5 mmol/g or less. For example, in the case where the functional group is an epoxy group, the concentration of the epoxy group may be determined from the epoxy equivalent obtained by the method in according with JIS K 7236-1995.

Illustrative examples of the component (B) include a carboxyl-containing monomer, an acid anhydride-containing monomer, an epoxy-containing monomer such as a glycidyl-containing monomer, a hydroxy-containing monomer, an amino-containing monomer, and an isocyanate-containing monomer.

Illustrative examples of the carboxyl-containing monomer include (meth)acrylic acid, succinic acid, cinnamic acid, and crotonic acid.

Illustrative examples of the acid anhydride-containing monomer include (meth)acrylic anhydride, maleic anhydride, succinic anhydride, itaconic anhydride, phthalic anhydride, tetrahydrophthalic anhydride, hexahydrophthalic anhydride, trimellitic anhydride, pyromellitic anhydride, and benzophenone tetracarboxylic dianhydride.

Illustrative examples of the epoxy-containing monomer include glycidyl (meth)acrylate, glycidyl 4-hydroxybutyl (meth)acrylate, and allyl glycidyl ether.

Illustrative examples of the hydroxy-containing monomer include 2-hydroxyethyl (meth)acrylate, 4-hydroxybutyl (meth)acrylate, 5-hydroxypentyl (meth)acrylate, 6-hydroxyhexyl (meth)acrylate, 8-hydroxyoctyl (meth)acrylate, 10-hydroxydecyl (meth)acrylate, (4-hydroxymethyl) cyclohexylmethyl (meth)acrylate, 2-hydroxypropyl (meth)acrylate, 2-hydroxybutyl (meth)acrylate, 2-hydroxy-3-phenoxypropyl (meth)acrylate, 3-chloro-2-hydroxypropyl (meth)acrylate, 2-hydroxy-3-phenoxypropyl (meth)acrylate, 2,2-dimethyl-2-hydroxyethyl (meth)acrylate, N-methylol (meth)acrylamide, and N-hydroxyethyl (meth)acrylamide.

Illustrative examples of the amino-containing monomer include dimethylaminoethyl (meth)acrylate and diethylaminoethyl (meth)acrylate.

Illustrative examples of the isocyanate-containing monomer include 2-(meth)acryloyloxyethyl isocyanate.

The term (meth)acrylate includes a methacrylate, an acrylate, and a combination of them. The methacrylic acid and the acrylic acid are sometimes collectively referred to as (meth)acrylic acid.

Among them, from the viewpoint of clearly obtaining the advantageous effects of the present invention, the component (B) is preferably one or more monomers selected from a carboxyl-containing monomer, an acid anhydride-containing monomer, and an epoxy-containing monomer. It is more preferable to use a combination of an acid anhydride-containing monomer and an epoxy-containing monomer. The acid anhydride-containing monomer is preferably (meth)acrylic acid anhydride. The epoxy-containing monomer is preferably a compound having one epoxy group and one or more ethylenic unsaturated groups in one molecule thereof; especially, glycidyl (meth)acrylate is more preferable. In particular, from the viewpoint of clearly obtaining the advantageous effects of the present invention, the component (B) is used preferably in a combination of (meth)acrylic acid anhydride and glycidyl (meth)acrylate.

As for the component (B), a commercially available product may be used. Illustrative examples of the commercially available product of the component (B) include "4HBAGE" manufactured by Mitsubishi Chemical Corp. and "Neoallyl G" manufactured by Osaka Soda Co., Ltd.

From the viewpoint of clearly obtaining the advantageous effects of the present invention, the viscosity of the component (B) at 25°C is preferably 1 Pa·s or less, more preferably 100 mPa·s or less, and still more preferably 50 mPa·s or less, or 10 mPa·s or less. There is no particular restriction in the lower limit thereof, and this may be, for example, 0.1 mPa·s or more, 0.3 mPa·s or more, or 1 mPa·s or more. The viscosity may be measured, for example, using an oscillating viscometer. In the case where two or more of the component (B) are included, it is preferable to include at least one component (B) that has the viscosity of 50 mPa·s or less at 25°C.

The weight-average molecular weight (Mw) of the component (B) is preferably 10 to 10,000, more preferably 20 to 5,000, still more preferably 30 to 1,000, and especially preferably 50 to 500.

From the viewpoint of clearly obtaining the advantageous effects of the present invention, the content of the component (B) relative to 100% by mass of the resin components in the underfill material is preferably 10% by mass or more, more preferably 15% by mass or more, still more preferably 20% by mass or more, and preferably 60% by mass or less, more preferably 55% by mass or less, and still more preferably 50% by mass or less.

The molar ratio of all the epoxy groups in the component (A) to all the functional groups in the component (B) (all epoxy groups in the component (A) : all functional groups in the component (B)) is preferably in the range of 30:70 to 80:20, and more preferably in the range of 40:60 to 60:40. Inclusion of the component (A) and the component (B) in the underfill material with the quantity ratio as described above makes it possible to clearly obtain the advantageous effects of the present invention.

### <(C) Inorganic Filler>

The underfill material contains (C) an inorganic filler as the component (C). Illustrative examples of the inorganic filler (C) include silica, alumina, barium sulfate, talc, clay, mica powder, aluminum hydroxide, magnesium hydroxide, calcium carbonate, magnesium carbonate, magnesium oxide, boron nitride, aluminum borate, barium titanate, strontium titanate, barium titanate, calcium titanate, magnesium titanate, bismuth titanate, titanium dioxide, barium zirconate, and calcium zirconate. Among these, silica is preferable. Illustrative examples of the silica include an amorphous silica, a fused silica, a crystalline silica, a synthetic silica, and a hollow silica. In addition, the silica is preferably a spherical silica. The inorganic filler (C) may be used singly or in a combination of two or more of those described above.

The inorganic filler (C) may be classified into (C-1) an inorganic filler having an average particle diameter of more than 0.05 um and (C-2) an inorganic filler having an average particle diameter of 0.05 um or less. The inclusion of the component (C-1) in the underfill material makes it possible to enhance the elastic modulus of the cured product of the underfill material. With this, not only a warpage of the cured product may be suppressed, but also a reflow resistance and a crack resistance may be enhanced. In addition, the inclusion of the component (C-2) in the underfill material makes it possible to suppress sedimentation of components included in the underfill material. The inorganic filler (C) may contain the component (C-2) together with the component (C-1). It is preferable that the inorganic filler (C) contains either the component (C-1) or the component (C-2), but it is more preferable to contain both the component (C-1) and the component (C-2).

The average particle diameter of the component (C-1) is preferably more than 0.05 um, more preferably 0.1 um or more, still more preferably 0.3 um or more, or 1.0 um or more, and preferably 25 um or less, more preferably 15 um or less, and still more preferably 10 um or less.

Illustrative examples of the commercially available product of the component (C-1) include "UFP-30" (manufactured by Denka Co., Ltd.); "YC100C", "YA050C", "YA050C-MJE", "YA010C", "SC2500SQ", "SO-C4", "SO-C2", "SO-C1", and "SC-C2" (all manufactured by Admatechs Co., Ltd.); and "Silfil NSS-3N", "Silfil NSS-4N", and "Silfil NSS-5N" (all manufactured by Tokuyama Corp.).

From the viewpoint of clearly obtaining the advantageous effects of the present invention, the average particle diameter of the component (C-2) is preferably 0.05 um or less, more preferably 0.03 um or less, still more preferably 0.02 um or less, and preferably 0.001 um or more, more preferably 0.003 µm or more, and still more preferably 0.005 um or more.

Illustrative examples of the commercially available product of the component (C-2) include "Aerosil 200", "Aerosil R805", and "Aerosil RY300" (all manufactured by Nippon Aerosil Co., Ltd.).

The average particle diameter of the inorganic filler (C) may be measured by a laser diffraction and scattering method based on the Mie scattering theory. Specifically, the particle size distribution of the inorganic filler is measured by using a laser diffraction scattering particle size distribution measurement instrument to create a volume-based particle size distribution of the inorganic filler, then the average particle diameter is determined by the median diameter thereof. The measurement sample to be used may be prepared by weighing 100 mg of the inorganic filler and 10 g of methyl ethyl ketone into a vial, which is then followed by dispersing it by means of an ultrasound for 10 minutes. Using a laser diffraction particle size distribution measurement instrument with blue and red light source wavelengths, the volume-based particle size distribution of the inorganic filler (C) in the measurement sample is measured by the flow cell method; then, the average particle diameter may be calculated as the median diameter from the particle size distribution thus obtained. Illustrative examples of the laser diffraction particle size distribution measurement instrument include "LA-960" manufactured by HORIBA, Ltd.

The inorganic filler is preferably those whose surfaces are modified with a surface modifying agent in order to enhance the moisture resistance and dispersibility thereof. Illustrative examples of the surface modifying agent include an aminosilane type coupling agent, a ureidosilane type coupling agent, an epoxysilane type coupling agent, a mercaptosilane type coupling agent, a vinyl silane type coupling agent, a styryl silane type coupling agent, an acrylate silane type coupling agent, an isocyanate silane type coupling agent, a sulfido silane type coupling agent, an organosilazane type compound, a titanate type coupling agent, and an alkoxysilane.

Illustrative examples of the commercially available product of the surface modifying agent include "KBM22" (dimethyl dimethoxy silane) manufactured by Shin-Etsu Chemical Co., Ltd.; "KBM403" (3-glycidoxypropyl trimethoxy silane) manufactured by Shin-Etsu Chemical Co., Ltd.; "KBM803" (3-mercaptopropyl trimethoxy silane) manufactured by Shin-Etsu Chemical Co., Ltd.; "KBE903" (3-aminopropyl triethoxy silane) manufactured by Shin-Etsu Chemical, Co., Ltd.; "KBM573" (N-phenyl-3-aminopropyl trimethoxy silane) manufactured by Shin-Etsu Chemical Co., Ltd.; "KBM5783" (N-phenyl-3-aminooctyl trimethoxy silane) manufactured by Shin-Etsu Chemical Co., Ltd.; "SZ-31" (hexamethyl disilazane) manufactured by Shin-Etsu Chemical Co., Ltd.; "KBM103" (phenyl trimethoxy silane) manufactured by Shin-Etsu Chemical Co., Ltd.; and "KBM-4803" (long-chain epoxy type silane coupling agent) manufactured by Shin-Etsu Chemical Co., Ltd. Among these, a nitrogen atom-containing silane coupling agent is preferable, an aminosilane coupling agent containing a phenyl group is more preferable, and N-phenyl-3-aminoalkyl trimethoxy silane is still more preferable. The surface modifying agent may be used singly, or in a combination of two or more of those described above in any ratio.

The degree of surface modification by the surface modifying agent may be assessed by the amount of carbon per unit surface area of the inorganic filler (C). From the viewpoint of enhancement of the dispersibility of the inorganic filler (C), the amount of carbon per unit surface area of the inorganic filler (C) is preferably 0.02 mg/m² or more, more preferably 0.1 mg/m² or more, and especially preferably 0.2 mg/m² or more. On the other hand, from the viewpoint of suppressing the increase in the melt viscosity of the underfill material, the amount of carbon mentioned above is preferably 1 mg/m² or less, more preferably 0.8 mg/m² or less, and especially preferably 0.5 mg/m² or less.

The amount of carbon per unit surface area of the inorganic filler (C) may be measured after the surface-modified inorganic filler (C) is washed with a solvent (e.g., methyl ethyl ketone) (hereinafter this is sometime referred to as "MEK"). Specifically, a sufficient amount of methyl ethyl ketone is mixed with the surface-modified inorganic filler (C), which is then followed by washing by means of an ultrasound at 25°C for 5 minutes. Next, after removing the supernatant liquid and drying the solid portion remained, the amount of carbon per unit surface area of the inorganic filler (C) may be measured using a carbon analyzer. As for the carbon analyzer, "EMIA-320V" manufactured by HORIBA, Ltd. may be used.

The content of the inorganic filler (C) (total content of the component (C-1) and the component (C-2)) relative to 100% by mass of the components in the underfill material is preferably 60% by mass or more, more preferably 65% by mass or more, still more preferably 70% by mass or more, or 75% by mass or more, and preferably 95% by mass or less, more preferably 90% by mass or less, still more preferably 85% by mass or less, or 80% by mass or less. The underfill material of the present invention has a low viscosity because it contains the component (B) and, if necessary, the component (D) to be described later. Because of this, the viscosity of the underfill material may be kept low even when a large amount of the inorganic filler (C) is included. As a result, it becomes possible not only to improve the filling time and filling speed of the underfill material, but also to obtain the cured product of the underfill material having a high elastic modulus. The increase in the elastic modulus makes it possible not only to suppress the warpage but also to enhance a reflow resistance and a crack resistance. The term "components in the underfill material" refers to all the components in the underfill material.

The content of the component (C-1) relative to 100% by mass of the components in the underfill material is preferably 60% by mass or more, more preferably 65% by mass or more, still more preferably 70% by mass or more, or 75% by mass or more, and preferably 95% by mass or less, more preferably 90% by mass or less, and still more preferably 85% by mass or less, or 80% by mass or less.

From the viewpoint of clearly obtaining the advantageous effects of the present invention, the content of the component (C-2) relative to 100% by mass of the components in the underfill material is preferably 0.01% by mass or more, more preferably 0.05% by mass or more, or 0.1% by mass or more, and the upper limit thereof is preferably 1.5% by mass or less, and more preferably 1% by mass or less, or 0.5% by mass or less.

### <(D) Compound Having an Ethylenic Unsaturated Group Not Containing a Functional Group Capable of Reacting with the Component (A)>

The underfill material may contain, as the optional component (D), a compound having an ethylenic unsaturated group not containing a functional group that is capable of reacting with the component (A). The inclusion of the component (D) in the underfill material makes it possible to lower the viscosity of the underfill material, thereby resulting in decrease in the filling time thereof. The component (D) does not include those that fall under the components (A) through (C) described above. The component (D) may be used singly or in a combination of two or more of those described above.

From the viewpoint of clearly obtaining the advantageous effects of the present invention, as for the component (D), a compound having an ethylenic unsaturated group not containing a functional group that is capable of reacting with the component (A) may be used. The functional group that is capable of reacting with the component (A) and the ethylenic unsaturated group are as those described before.

Illustrative examples of the component (D) include a (meth)acrylate ester, an aromatic unsaturated monomer such as a styrene type monomer, a heterocyclic unsaturated monomer, and a diene.

Illustrative examples of the (meth)acrylate ester include methyl (meth)acrylate, ethyl (meth)acrylate, propyl (meth)acrylate, butyl (meth)acrylate, octyl (meth)acrylate, lauryl (meth)acrylate, 2-hydroxyethyl (meth)acrylate, cyclohexyl (meth)acrylate, methylcyclohexyl (meth)acrylate, isobornyl (meth)acrylate, cyclododecyl (meth)acrylate, and phenoxyethyleneglycol (meth)acrylate.

As for the aromatic unsaturated monomer, a compound containing an aromatic ring and a ethylenic carbon-carbon unsaturated bond may be used. Illustrative examples thereof include styrene, α-methylstyrene, 4-methylstyrene, 2-methylstyrene, 3-methylstyrene, 4-methoxystyrene, p-t-butylstyrene, p-n-butylstyrene, p-tert-butoxystyrene, 2-hydroxymethylstyrene, 2-chlorostyrene, 4-chlorostyrene, 2,4-dichlorostyrene, 1-vinylnaphthalene, divinylbenzene, 2-acetoxystyrene, 3-acetoxystyrene, 4-acetoxystyrene, 4-vinylphenyl benzoate, and p-styrenesulfonic acid or an alkali metal salt thereof (sodium salt, potassium salt, etc.).

Illustrative examples of the heterocyclic unsaturated monomer include 2-vinylthiophene, N-methyl-2-vinylpyrrole, 1-vinyl-2-pyrrolidone, 2-vinylpyridine, and 4-vinylpyridine.

Illustrative examples of the diene include: α-olefins such as 1-hexene, 1-octene, and 1-decene; and butadiene, isoprene, 4-methyl-1,4-hexadiene, and 7-methyl-1,6-octadiene.

Among them, from the viewpoint of clearly obtaining the advantageous effects of the present invention, the component (D) is preferably one or more monomers selected from a (meth)acrylate ester and an aromatic unsaturated monomer (styrene type monomers).

A commercially available product may be used as the component (D). Illustrative examples of the commercially available product include "PHE-1G" (phenoxyethyleneglycol methacrylate) manufactured by Nakamura Chemical Co., Ltd.; "Light Ester BZ" (benzyl methacrylate) manufactured by Kyoeisha Chemical Co., Ltd.; and "Light Ester IB-X" (isobornyl methacrylate) manufactured by Kyoeisha Chemical Co., Ltd.

From the viewpoint of clearly obtaining the advantageous effects of the present invention, the viscosity of the component (D) at 25°C is preferably 1 Pa·s or less, more preferably 100 mPa·s or less, and still more preferably 50 mPa·s or less. There is no particular restriction in the lower limit thereof, and this may be made, for example, 0.1 mPa·s or more, 0.2 mPa·s or more, or 0.3 mPa·s or more. The viscosity may be measured, for example, using an oscillating viscometer. In the case where two or more of the component (D) are included, it is preferable to include at least one component (D) that has the viscosity of 50 mPa·s or less at 25°C.

The weight-average molecular weight (Mw) of the component (D) is preferably 10 to 10,000, more preferably 20 to 5,000, still more preferably 30 to 1,000, and especially preferably 50 to 500.

From the viewpoint of clearly obtaining the intended effects of the present invention, the content of the component (D) relative to 100% by mass of the resin components in the underfill material is preferably 10% by mass or more, more preferably 15% by mass or more, still more preferably 20% by mass or more, and preferably 70% by mass or less, more preferably 60% by mass or less, and still more preferably 55% by mass or less, or 50% by mass or less.

When the content of the component (D) relative to 100% by mass of the resin components is represented by D1 and the content of the component (B) relative to 100% by mass of the resin components is represented by B1, B1/D1 is preferably 0.1 or more, more preferably 0.5 or more, still more preferably 0.8 or more, or 1 or more, and preferably 5 or less, more preferably 3 or less, and still more preferably 2 or less, 1.9 or less, or 1.8 or less. By controlling the content of the component (B) and the component (D) such that B1/D1 falls within the range described above, it is possible to clearly obtain the advantageous effects of the present invention.

### <(E) Radical Polymerization Catalyst>

The underfill material may further contain (E) a radical polymerization catalyst as the optional component. At the time when the underfill material is cured, the inclusion of the radical polymerization catalyst (E) makes it possible not only to accelerate the reaction of the component (B) with the component (D) but also to efficiently control the curing time and the curing temperature. The component (E) does not include those that fall under components (A) through (D) described above. The component (E) may be used singly or in a combination of two or more of those described above.

The radical polymerization catalyst (E) is preferably a thermal radical polymerization catalyst that generates a radical when a thermal energy is given.

Illustrative examples of the thermal radical polymerization catalyst include: dialkyl peroxides such as di-t-butyl peroxide, dicumyl peroxide, and t-hexyl peroxy-2-ethyl hexanoate; diacyl peroxides such as lauroyl peroxide, benzoyl peroxide, benzoyl toluyl peroxide, and toluyl peroxide; peracid esters such as t-butyl peracetate, t-butyl peroxyoctoate, and t-butyl peroxybenzoate; ketone peroxides; peroxycarbonates; peroxyketals such as 1,1-di(t-amylperoxy)cyclohexane; azonitrile compounds such as 2,2'-azobis(2,4-dimethylvaleronitrile), 2,2'-azobis(isobutyronitrile), 2,2'-azobis(2-methylbutyronitrile), and 2,2'-azobis(4-methoxy-2,4-dimethylvaleronitrile); azoamide compounds such as 2,2'-azobis{2-methyl-N-[1,1-bis(hydroxymethyl)-2-hydroxyethyl]propionamide}; azoamidine compounds such as 2,2'-azobis(2-amidinopropane) dihydrochloride and 2,2'-azobis[2-(2-imidazolin-2-yl)propane] dihydrochloride; azoalkane compounds such as 2,2'-azobis(2,4,4-trimethylpentane) and 4,4'-azobis(4-cyanopentanoic acid); azo compounds having an oxime skeleton such as 2,2'-azobis(2-methylpropionamide oxime); and azo compounds such as dimethyl 2,2'-azobis(isobutyrate). The thermal radical polymerization catalyst may be used singly or in a combination of two or more of those described above. Among the above radical polymerization catalysts, the dialkyl peroxides, the diacyl peroxides, the peracid esters, the ketone peroxides, the peroxycarbonates, and the peroxyketals are also collectively called "peroxide type radical polymerization catalyst".

From the viewpoint of clearly obtaining the advantageous effects of the present invention, it is preferable to use the peroxide type thermal radical polymerization catalyst as the radical polymerization catalyst (E).

The content of the radical polymerization catalyst (E) relative to 100% by mass of the resin components in the underfill material is preferably 0.1% by mass or more, more preferably 0.2% by mass or more, or 0.3% by mass or more, and preferably 3% by mass or less, more preferably 2% by mass or less, 1.8% by mass or less, 1.5% by mass or less, or 1% by mass or less.

### <(F) Organic Base>

The underfill material may further contain (F) an organic base as the optional component. At the time when the underfill material is cured, the inclusion of the organic base (F) makes it possible not only to accelerate the reaction of the component (A) with the component (B) but also to efficiently control the curing time and the curing temperature. The component (F) does not include those that fall under the components (A) through (E) described above. The component (F) may be used singly or in a combination of two or more of those described above.

As for the organic base (F), it is preferable to use one or more curing accelerators that have been publicly known as the curing accelerator for an epoxy resin, selected from an amine type curing accelerator, an organophosphorus type curing accelerator, and an imidazole type curing accelerator.

Illustrative examples of the amine type curing accelerator include trialkylamines such as triethylamine and tributylamine; 4-dimethylaminopyridine, benzyldimethylamine, 2,4,6,-tris(dimethylaminomethyl)phenol, and 1,8-diazabicyclo(5,4,0)-undecene.

As for the organophosphorus type curing accelerator, one or more organophosphorus type curing accelerators selected from the group consisting of a phosphonium salt and a phosphines are preferable.

Illustrative examples of the phosphonium salt include: aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, bis(tetrabutylphosphonium) pyromellitate, tetrabutylphosphonium hydrogen hexahydrophthalate, tetrabutylphosphonium 2,6-bis[(2-hydroxy-5-methylphenyl)methyl]-4-methylphenolate, and di-tert-butylmethylphosphonium tetraphenylborate; and aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate.

Illustrative examples of the phosphine include: aliphatic phosphines such as tributyl phosphine, tri-tert-butyl phosphine, tri-octyl phosphine, di-tert-butyl(2-butenyl) phosphine, di-tert-butyl(3-methyl-2-butenyl) phosphine, and tricyclohexyl phosphine; aromatic phospines such as dibutylphenyl phosphine, di-tert-butylphenyl phosphine, methyldiphenyl phosphine, ethyldiphenyl phosphine, butyldiphenyl phosphine, diphenylcyclohexyl phosphine, triphenylphosphine, tri-o-tolyl phosphine, trim-tolyl phosphine, tri-p-tolyl phosphine, tris(4-ethylphenyl) phosphine, tris(4-propylphenyl) phosphine, tris(4-isopropylphenyl) phosphine, tris(4-butylphenyl) phosphine, tris(4-tert-butylphenyl) phosphine, tris(2,4-dimethylphenyl) phosphine, tris(2,5-dimethylphenyl) phosphine, tris(2,6-dimethylphenyl) phosphine, tris(3,5-dimethylphenyl) phosphine, tris(2,4,6-trimethylphenyl) phosphine, tris(2,6-dimethyl-4-ethoxyphenyl) phosphine, tris(2-methoxyphenyl) phosphine, tris(4-methoxyphenyl) phosphine, tris(4-ethoxyphenyl) phosphine, tris(4-tert-butoxyphenyl) phosphine, diphenyl-2-pyridyl phosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino)diphenyl ether; aromatic phosphine-borane complexes such as triphenylphosphine triphenylborane; and products of an aromatic phosphine-quinone addition reaction, such as triphenylphosphine/p-benzoquinone addition product.

Illustrative examples of the imidazole type curing accelerator include 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamidino-6-[2'-undecylimidazolyl-(1')]-ethyl-s-triazine, 2,4-diamidino-6-[2'-ethyl-4'-methylimidazolyl-(1')]-ethyl-s-triazine, 2,4-diamidino-6-[2'-methylimidazolyl-(1')]-ethyl-s-triazine isocyanurate adduct, 2-phenylimidazole isocyanurate adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, 2-phenylimidazoline, and other imidazole compounds and adducts of an imidazole compound with an epoxy resin.

The content of the organic base (F) relative to 100% by mass of the resin components in the underfill material is preferably 0.1% by mass or more, more preferably 0.2% by mass or more, or 0.3% by mass or more, and preferably 3% by mass or less, more preferably 2% by mass or less, 1.8% by mass or less, 1.5% by mass or less, or 1% by mass or less.

### <(G) Organic Filler>

The underfill material may further contain (G) an organic filler as the optional component. The component (G) does not include those that fall under the components (A) through (F) described above. The inclusion of the component (G) in the underfill material makes it possible to suppress sedimentation of the component included in the underfill material. The component (G) may be used singly or in a combination of two or more of those described above.

The component (G) is present in the form of particle in the underfill material and is usually included in its cured product with maintaining its particle form. As for the component (G), any organic filler that may be used to form an insulating material for electronic components such as a semiconductor chip package and a printed wiring board may be used; illustrative examples thereof include a rubber particle, a polyamide particle, a silicone particle, an LCP powder, and a PPS powder.

There is no particular restriction in the rubber particle as long as it is fine particle of a resin that is chemically cross-linked with a resin that exhibits rubber elasticity and is made insoluble and non-melting in an organic solvent. Illustrative examples thereof include a hollow polymer particle, an acrylonitrile butadiene rubber particle, a butadiene rubber particle, and an acrylic rubber particle. Illustrative examples of the rubber particle include specifically XER-91 (manufactured by Japan Synthetic Rubber Co., Ltd.); Staphyloid AC3355, AC3816, AC3816N, AC3832, AC4030, AC3364, and IM101 (all are manufactured by Aica Kogyo Co., Ltd.); and Paraloid EXL2655 and EXL2602 (both are manufactured by Dow Chemical Co.).

The average particle diameter of the organic filler is preferably in the range of 0.005 um to 100 µm, and more preferably in the range of 0.2 um to 15 um. The average particle diameter of the organic filler may be measured using a dynamic light scattering method. For example, the organic filler is uniformly dispersed in an appropriate organic solvent by means of an ultrasonic wave or the like, and the particle size distribution of the organic filler on the mass basis is obtained using a concentrated particle size analyzer ("FPAR-1000" manufactured by Otsuka Electronics Co., Ltd.) to obtain a median diameter as the average particle diameter.

The content of the organic filler (G) relative to 100% by mass of the components in the underfill material is preferably 0.5% by mass or more, more preferably 1% by mass or more, 1.5% by mass or more, or 1.8% by mass or more, and the upper limit thereof is preferably 10% by mass or less, more preferably 8% by mass or less, 6% by mass or less, or 5% by mass or less.

### <(H) Optional Additive>

The underfill material of the present invention may further contain any additive as long as it does not impair the advantageous effects of the present invention. Illustrative examples of the additive as described above include a thermosetting resin other than the component (A); a thermoplastic resin; epoxy resin curing agents such as a phenol type curing agent, a benzoxazine type curing agent, an acid anhydride type curing agent, a cyanate ester type curing agent, and an active ester type curing agent; organometallic compounds such as an organocopper compound, an organozinc compound, and an organocobalt compound; coloring agents such as a phthalocyanine blue, a phthalocyanine green, an iodine green, a diazo yellow, a crystal violet, titanium dioxide, and carbon black; polymerization inhibitors such as hydroquinone, catechol, pyrogallol, and phenothiazine; leveling materials such as a silicone type leveling material and an acrylic polymer type leveling material; thickening agents such as benton and montmorillonite; defoaming agents such as a silicone type defoaming agent, an acrylic type defoaming agent, a fluorine type defoaming agent, and a vinyl resin type defoaming agent; UV absorbers such as a benzotriazole type UV absorber; adhesion improvers such as a urea silane; adhesion enhancers such as a triazole type adhesion enhancer, a tetrazole type adhesion enhancer, and a triazine type adhesion enhancer; antioxidants such as a hindered phenol type antioxidant; fluorescent brighteners such as a stilbene derivative; surfactants such as a fluorine type surfactant and a silicone type surfactant; flame retardants such as phosphorus type flame retardants (such as a phosphate ester compound, a phosphazene compound, a phosphinic acid compound, and a red phosphorous), nitrogen type flame retardants (such as melamine sulfate), halogen type flame retardants, and inorganic flame retardants (such as antimony trioxide); dispersants such as a phosphate ester type dispersant, a polyoxyalkylene type dispersant, an acetylene type dispersant, a silicone type dispersant, an anionic dispersant, and a cationic dispersant; and stabilizers such as a borate type stabilizer, a titanate type stabilizer, an aluminate type stabilizer, a zirconate type stabilizer, an isocyanate type stabilizer, a carboxylic acid type stabilizer, and a carboxylic acid anhydride type stabilizer. The content of the additives as described above may be determined in accordance with the required properties of the underfill material.

### <(I) Organic Solvent>

The underfill material may further contain an organic solvent as a volatile component. Illustrative examples of the organic solvent include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethylene glycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butylcarbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; aromatic hydrocarbon type solvents such as benzene, toluene, xylene, ethylbenzene, and trimethylbenzene. The organic solvent may be used singly or in a combination of two or more of those described above.

Because the underfill material of the present invention contains the component (A) and the component (B) in combination, it is possible to lower the viscosity even when the content of the organic solvent is low or the organic solvent is not present. Therefore, the content of the organic solvent in the underfill material may be decreased to, for example, 5% by mass or less, 4% by mass or less, 2% by mass or less, 1% by mass or less, 0.5% by mass or less, or even 0% by mass (solvent-free system).

The underfill material may be prepared by mixing necessary components out of the components described above, and also, as needed, it may be kneaded or mixed by a kneading means such as three rolls, a ball mill, a bead mill, a sand mill, or a stirring means such as a super mixer or a planetary mixer.

### <Physical Properties and So Forth of the Underfill Material>

Because the underfill material contains the component (B) and, if necessary, the component (D), even when the content of the inorganic filler (C) is high, it is possible to have a low viscosity at 40°C thereby exhibiting a superior flowability. Therefore, the filling speed of the underfill material is so fast that the filling time of the underfill material may be shortened even in a large multiple die package. The viscosity of the underfill material at 40°C is preferably 2000 mPa·s or less, more preferably 1500 mPa·s or less, and still more preferably 1000 mPa·s or less, 700 mPa·s or less, 500 mPa·s or less, 400 mPa·s or less, or 300 mPa·s or less. There is no particular restriction in the lower limit thereof, and this may be made 1 mPa·s or more, 10 mPa·s or more, or the like. The viscosity of the underfill material may be measured by the method described in Examples to be described later.

The underfill material exhibits the characteristic of a high filling speed due to its low viscosity. Therefore, when filling the gap between a circuit board and a semiconductor chip with the underfill material, the filling speed of the underfill material may be made faster. The filling speed is preferably 5 mm/min or more, more preferably 8 mm/min or more, and still more preferably 10 mm/min or more, or 15 mm/min or more. There is no particular restriction in the upper limit thereof, and this may be made 100 mm/min or less, or the like. The filling speed may be measured by the method described in Examples to be described later.

The underfill material exhibits the characteristic of a high filling speed due to its low viscosity. Therefore, when filling the gap between a circuit board and a semiconductor chip with the underfill material, the filling speed of the underfill material may be made faster. For example, a test module having an area of 900 cm² and a gap of 100 um is prepared. The test module is heated, and the underfill material is dropped into the module by means of a syringe. The time to complete the filling (filling time) is preferably less than 120 minutes, more preferably 100 minutes or less, and still more preferably 50 minutes or less, 40 minutes or less, 30 minutes or less, or 25 minutes or less. There is no particular restriction in the upper limit thereof, and this may be made 1 minute or more, or the like. The filling speed may be measured by the method described in Examples to be described later.

The cured product of the underfill material obtained by heating at 100°C for 5 hours has a characteristic of a high elastic modulus at 250°C. Therefore, it is possible to obtain the cured product having a superior crack resistance. The elastic modulus of the cured product of the underfill material at 250°C is preferably 1.0 GPa or more, more preferably 1.5 GPa or more, and still more preferably 2.0 GPa or more, or 2.5 GPa or more. There is no particular restriction in the upper limit thereof, and this may be made 10 GPa or less, or the like. The elastic modulus may be measured by the method described in Examples to be described later.

The cured product obtained by curing the underfill material at 100°C for 5 hours usually exhibits the characteristic of a high glass transition temperature (Tg). The glass transition temperature thereof is preferably 150°C or higher, more preferably 155°C or higher, and still more preferably 160°C or higher, or 180°C or higher. There is no particular restriction in the upper limit thereof, and this may be made 300°C or lower, or the like. The glass transition temperature may be measured by the method described in Examples to be described later.

The cured product obtained by curing the underfill material at 100°C for 5 hours usually exhibits the characteristic of a large cure shrinkage. Therefore, it is possible to obtain the cured product having a superior crack resistance. The cure shrinkage is preferably 1% or more, more preferably 2% or more, and still more preferably 3% or more. There is no particular restriction in the lower limit thereof, and this may be made 25% or less, or the like. The cure shrinkage may be measured by the method described in Examples to be described later.

The cured product obtained by curing the underfill material at 100°C for 5 hours usually exhibits the characteristic of a low average coefficient of thermal expansion (CTE). Therefore, it is possible to obtain the cured product having a superior crack resistance. The average coefficient of thermal expansion between the temperature above the glass transition temperature (Tg) by 40°C and 260°C is preferably 100 ppm or less, more preferably 75 ppm or less, and still more preferably 50 ppm or less, or less than 50 ppm. There is no particular restriction in the lower limit thereof, and this may be made 1 ppm or more, or the like. The average coefficient of thermal expansion may be measured by the method described in Examples to be described later.

The underfill material exhibits the characteristic of a low volatility. Therefore, this is useful as the underfill material for the post-application method (capillary underfill method), and has the characteristic that the cured product having a superior crack resistance may be obtained. The volatility is measured by weighing 1 g of the underfill material followed by allowing it to leave on a hot plate heated at 40°C for 1 hour. The weight reduction rate at this time is preferably less than 10%, more preferably 7% or less, and still more preferably 4% or less, or less than 4%. There is no particular restriction in the lower limit thereof, and this may be made 0.01% or more, or the like. The volatility may be measured by the method described in Examples to be described later.

The underfill material of the present invention may be suitably used as the underfill material to fill the gap between a circuit board and a semiconductor chip, especially as the underfill material that is used in the post-application method (capillary underfill method). In addition, the underfill material of the present invention may be suitably used as the underfill material to fill the gap between a rewiring layer and a semiconductor chip and the gap between a circuit board and a rewiring layer. The underfill material of the present invention may be used in a wide range of field required, for example, as the underfill material for a semiconductor device including a multiple die package (underfill material used for a semiconductor device including a multiple die package), the underfill material for a semiconductor device including a semiconductor chip package having an area of 900 mm² or more (underfill material used for a semiconductor device including a semiconductor chip package having an area of 900 mm² or more), the underfill material for a semiconductor device including a fan-out type package (underfill material used for a semiconductor device including a fan-out type package), the underfill material for a semiconductor device including a semiconductor package including a silicon interposer (underfill material used for a semiconductor device including a semiconductor package including a silicon interposer), the underfill material for a semiconductor device including two or more semiconductor chips that are stacked in a vertical direction through a through-silicon via (underfill material used for a semiconductor device including a semiconductor chip package having two or more semiconductor chips stacked in a vertical direction through a through-silicon via).

### [Cured Product]

The cured product of the present invention is obtained by curing the underfill material of the present invention. This cured product is usually obtained by thermally curing the underfill material. At the time when the underfill material is thermally cured, volatile components such as the component (I) are usually removed, but the components (A) through (H) are not removed. Therefore, the cured product may contain components including the components (A) through (H) or reaction products thereof. The curing conditions of the underfill material may be those conditions to be described later. Preheating may be carried out before curing the underfill material, and heating may be carried out multiple times, including preheating.

### [Semiconductor Chip Package and Production Method of Same]

The semiconductor chip package of the present invention contains the cured product of the underfill material of the present invention. As mentioned earlier, there is a growing need for semiconductor chip packages such as a large die package of 900 mm² or more, and a multiple die package having a plurality of dies. The underfill material of the present invention has a superior flowability due to a low viscosity thereof. Thus, this enables to increase the filling speed of the underfill material.

The area of the large die package or of the semiconductor chip package is preferably 900 mm² or more, more preferably 1000 mm² or more, and even more preferably 1500 mm² or more. There is no particular restriction in the upper limit thereof, and this may be made 5000 mm² or less, or the like.

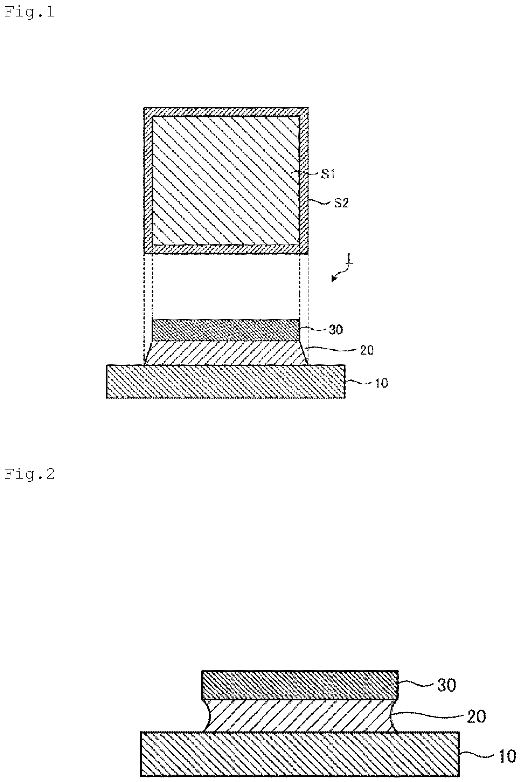

As can be seen in FIG. 1 and FIG. 2, a semiconductor chip package 1 of the present invention includes a circuit board 10, a semiconductor chip 30 bonded and mounted to the circuit board 10, and a cured product of the underfill material 20 of the present invention that fills the gap between the circuit board 10 and the semiconductor chip 30. The area of the semiconductor chip 30 is 900 mm² or more, and the preferable range of the area for the semiconductor chip 30 is the same as the area of the large die package.

When the projected area of a surface of the semiconductor chip 30 that is opposite to the circuit board side (this is sometimes referred to as the "projected area of the semiconductor chip surface") is represented by S1 (mm²), and the projected area of a surface of the cured product of the underfill material 20 that is opposite to the circuit board side (sometimes referred to as the "projected area of the cured product of the underfill material") is represented by S2 (mm²), then, (S2/S1) × 100 is preferably 120% or less, more preferably 110% or less, or more preferably 105% or less, and preferably 80% or more, more preferably 85% or more, and still more preferably 90% or more. When the value of (S2/S1) × 100 is made within the range described above, it is possible to decrease the area of the fillet and enhance the crack resistance.

The semiconductor chip package 1 may also have a so-called gouged shape, as illustrated in FIG. 2, in which the cross-sectional shape of the cured product of the underfill material 20 becomes smaller from the semiconductor chip 30 toward the center of the cured product of the underfill material 20 and becomes larger from the center of the cured product of the underfill material 30 toward the circuit board 10. The gouge shape of the cured product of the underfill material enhances the crack resistance.

The semiconductor chip package may be produced, for example, using the underfill material of the present invention, by the method including the step (2) below. The steps (1) and (3) below may also be included as necessary.
(1) A step of bonding a semiconductor chip to a circuit board,
(2) a step of filling the gap between the circuit board and the semiconductor chip or an interposer with the underfill material of the present invention; and
(3) a step of curing the underfill material.

The steps (1) through (3) are carried out preferably in the order of the step (1), the step (2), and the step (3).

### <Step (1)>

At the step (1), the semiconductor chip is bonded to the circuit board. The circuit board may be any conventionally known circuit board used to form a semiconductor chip package. The circuit board may have either a conductor layer or an insulating layer on one side or both sides thereof, in which either the conductor layer or the insulating layer may be patterned.

For example, when bonding the circuit board to the semiconductor chip, a method of forming a bump on the circuit board or on the semiconductor chip may be used. The method of forming the bump may be carried out according to those methods that are known to a person ordinarily skilled in the art in the production of the semiconductor chip package.

As for the bonding condition between the circuit board and the semiconductor chip, any condition that enables the conductor connection between a terminal electrode of the semiconductor chip and a circuit wiring of the circuit board may be used. For example, the condition used in the flip chip mounting of the semiconductor chip may be used.

Illustrative examples of the bonding method include the method in which the semiconductor chip is bonded to the circuit board by crimping. Crimping conditions are as follows. The crimping temperature is usually in the range of 120°C to 240°C (preferably in the range of 130°C to 200°C, more preferably in the range of 140°C to 180°C), and the crimping time is usually in the range of 1 second to 60 seconds (preferably 5 seconds to 30 seconds). Another bonding method is, for example, the method in which the semiconductor chip is placed on the circuit board followed by reflow bonding. The reflow condition may be made the temperature range of 120°C to 300°C.

### <Step (2)>

The step (2) is to fill the gap between the circuit board and the semiconductor chip with the underfill material of the present invention. Specifically, after the semiconductor chip is bonded to the circuit board, the gap between the semiconductor chip and the circuit board is filled with the underfill material of the present invention. As described earlier, the underfill material of the present invention has a low viscosity, so that it is possible to increase the filling speed. The gap is preferably 600 um or less, more preferably 200 um or less, and still more preferably 100 um or less. There is no particular restriction in the lower limit thereof, and this may be made 1 um or more, or the like.

The filling speed of the underfill material is 5 mm/min or more, preferably 8 mm/min or more, more preferably 10 mm/min or more, and still more preferably 15 mm/min or more. There is no particular restriction in the upper limit thereof, and this may be made 100 mm/min or less, or the like. The filling speed may be measured by the method described in Examples to be described later.

In the case that, for example, the area of the semiconductor chip package is 900 mm² or more and the gap is 100 um, the completion time of filling of the underfill material is less than 120 minutes, preferably 100 minutes or less, more preferably 50 minutes or less, and still more preferably 40 minutes or less, 30 minutes or less, or 25 minutes or less. There is no particular restriction in the upper limit thereof, and this may be made 1 minute or more, or the like. The completion time of the filling may be measured by the method described in Examples to be described later.

The method for filling the underfill material is, for example, the method in which the underfill material is dispensed near the side edge of the semiconductor chip thereby filling the gap between the semiconductor chip and the circuit board with the underfill material by utilizing a capillary action.

### <Step (3)>

At the step (3), the underfill material is cured to obtain the cured product of the underfill material in the gap between the circuit board and the semiconductor chip. There is no particular restriction in the curing condition of the underfill material, and the conditions usually used in formation of an insulating layer of a printed wiring board may be used.

The thermal curing condition of the underfill material varies depending on the type of the underfill material and so forth. In one embodiment, for example, the curing temperature is preferably 50°C to 250°C, more preferably 60°C to 240°C, and still more preferably 100°C to 200°C. The curing time may be made preferably 5 minutes to 600 minutes, more preferably 10 minutes to 500 minutes, and still more preferably 15 minutes to 400 minutes.

Prior to the thermal curing of the underfill material, the underfill material may be preliminarily heated at a temperature lower than the curing temperature. For example, prior to the thermal curing of the underfill material, the underfill material may be preliminarily heated at a temperature of 40°C to 120°C, preferably 50°C to 115°C, more preferably 60°C to 110°C, for 5 minutes or longer, preferably 5 minutes to 150 minutes, more preferably 15 minutes to 120 minutes, and still more preferably 15 minutes to 100 minutes.

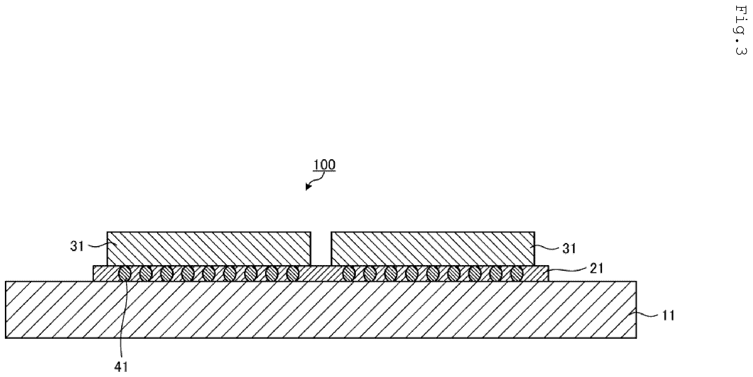

In another embodiment (second embodiment), as illustrated in FIG. 3, a semiconductor chip package 100 of the present invention is an aspect of a multiple die package that includes a circuit board 11, a plurality of semiconductor chips 31 that is bonded on the circuit board 11 via bumps 41, and a cured product of the underfill material 21 of the present invention that fills a gap between the circuit board 11 and the semiconductor chips 31. Because the underfill material of the present invention has a low viscosity, it is possible to increase the filling speed of the underfill material even for the multiple die package having a plurality of the semiconductor chips. The shape and the like of the circuit board and of the cured product of the underfill material used in the second embodiment are the same as those in the first embodiment.

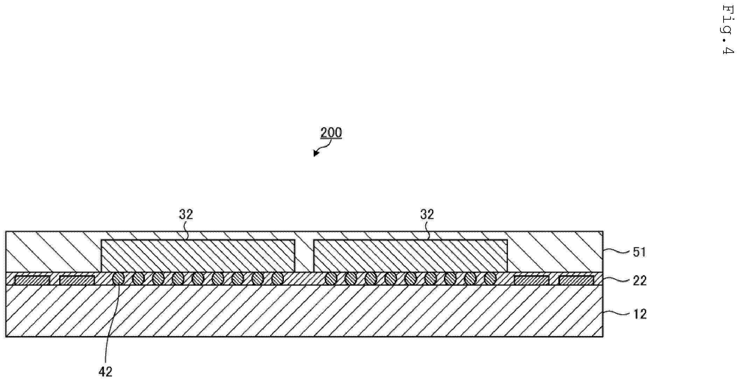

Another embodiment (the third form) is a fan-out type package. As illustrated in FIG. 4, a fan-out type package 200 includes a circuit board 12, a semiconductor chip 32 that is bonded on the circuit board 12 via bumps 42, a cured product of the underfill material 22 of the present invention that fills the gap between the circuit board 12 and the semiconductor chip 32, and an encapsulating layer 51 that is formed in such a way as to cover surrounding of the semiconductor chip 32. The low viscosity of the underfill material of the present invention enables faster filling of the underfill material, even in a large fan-out type package. The shape and the like of the circuit board and of the cured product of the underfill material used in the third embodiment are the same as those in the second embodiment. The insulating material used for the encapsulating layer may be the underfill material of the present invention or any other known insulating material.

The insulating material used in the encapsulating layer usually contains a large amount of an inorganic filler. Therefore, when the content of the inorganic filler in the underfill material is small, a crack may be generated at the interface between the cured product of the underfill material and the encapsulating layer. The underfill material of the present invention exhibits the characteristic of a low viscosity even when the content of the inorganic filler is high. Therefore, by increasing the content of the inorganic filler in the underfill material, it becomes possible to suppress generation of the crack at the interface with the encapsulating layer.

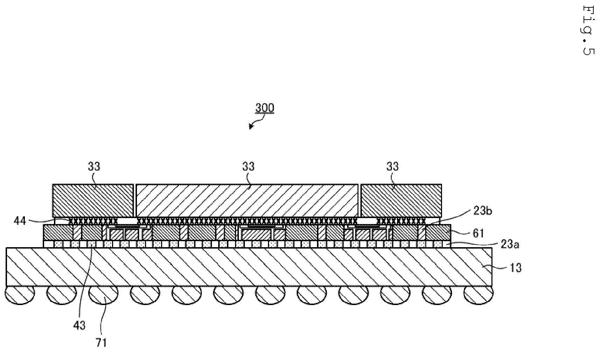

In another embodiment (fourth embodiment), as illustrated in FIG. 5, a semiconductor chip package 300 of the present invention includes a circuit board 13, a rewiring layer 61 that is bonded on the circuit board 13 via bumps 43, a semiconductor chip 33 that is bonded on the rewiring layer 61 via bumps 44, and cured products of the underfill material of the present invention 23a and 23b that fill the gap between the circuit board 13 and the rewiring layer 61 and the gap between the rewiring layer 61 and the semiconductor chip. As illustrated in FIG. 5, the fourth embodiment may have a plurality of the semiconductor chips, and also this may have bumps 49 on the surface of the circuit board 13 in the opposite side of semiconductor chip 33. The circuit board and so forth used in the fourth embodiment are the same as those used in the third embodiment. The cured products of the underfill material 23a and 23b may be the same or different underfill material.

The rewiring layer is a laminate consisting of, for example, a resin layer including a polyimide resin, a conductor layer, and a resin layer including a polyimide resin, in this order starting from the circuit board side. The material for the conductor layer includes one or more metals selected from the group consisting of gold, platinum, palladium, silver, copper, aluminum, cobalt, chromium, zinc, nickel, titanium, tungsten, iron, tin, and indium. The conductor layer may be a single metal layer or an alloy layer. The alloy layer is, for example, a layer formed from an alloy of two or more metals selected from the above group (e.g., nickel-chromium alloy, copper-nickel alloy, and copper-titanium alloy). Among them, from the viewpoint of versatility in formation of the conductor layer, cost, ease of patterning, and the like, a single metal layer of chromium, nickel, titanium, aluminum, zinc, gold, palladium, silver, or copper, and an alloy layer of nickel-chromium alloy, copper-nickel alloy, or copper-titanium alloy are preferable. A single metal layer of chromium, nickel, titanium, aluminum, zinc, gold, palladium, silver, or copper, and an alloy layer of nickel-chromium alloy are more preferable, and a single metal layer of copper is still more preferable. The resin layer including a polyimide resin may form a via hole as necessary so as to electrically connect the semiconductor chip and the circuit board through the via hole, which is not illustrated in the figure.

Because the underfill material of the present invention has a low viscosity, it is possible to increase the filling speed of the underfill material even in the package of the fourth embodiment. The underfill material of the present invention has a superior affinity with polyimide, so that it is possible to enhance the adhesion strength between the polyimide and the cured product of the underfill material. Therefore, even when the gap between the circuit board and the rewiring layer and the gap between the rewiring layer and the semiconductor chip are filled with the underfill material of the present invention, it is possible to suppress the peeling or the like at the interface between the rewiring layer and the cured product of the underfill material. The shape and the like of the circuit board and of the cured product of the underfill material used in the fourth embodiment are the same as those in the third embodiment.

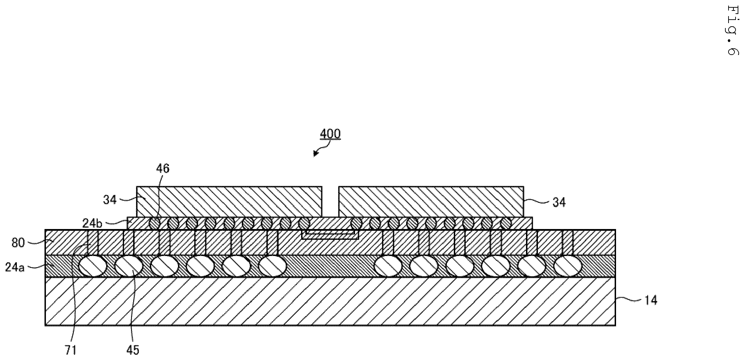

In another embodiment (fifth embodiment), as illustrated in FIG. 6, a semiconductor chip package 400 of the present invention includes a circuit board 14, a silicon interposer 80 that is bonded on the circuit board 14 via bumps 45, a semiconductor chip 34 that is bonded on the silicon interposer 80 via bumps 46, and cured products of the underfill material of the present invention 24a and 24b, which fill the gap between the circuit board 14 and the silicon interposer 80, and the gap between the silicon interposer 80 and the semiconductor chip 34. The silicon interposer 80 may have via holes 71 formed from a viewpoint of electrically connecting between the circuit board 14 and the semiconductor chip 34. The fifth embodiment may have a plurality of the semiconductor chips 34 as illustrated in FIG. 6. The cured products of the underfill materials 24a and 24b may be the same or different underfill material. Because the underfill material of the present invention has a low viscosity, it is possible to increase the filling speed of the underfill material even in the package of the fifth embodiment. The shape and the like of the circuit board and of the cured product of the underfill material used in the fifth embodiment are the same as those in the fourth embodiment.

The area of the silicon interposer is the same as the area of the semiconductor chip package; this is preferably 900 mm² or more, more preferably 1000 mm² or more, and still more preferably 1500 mm² or more. There is no particular restriction in the upper limit thereof, and this may be made 5000 mm² or less, or the like.

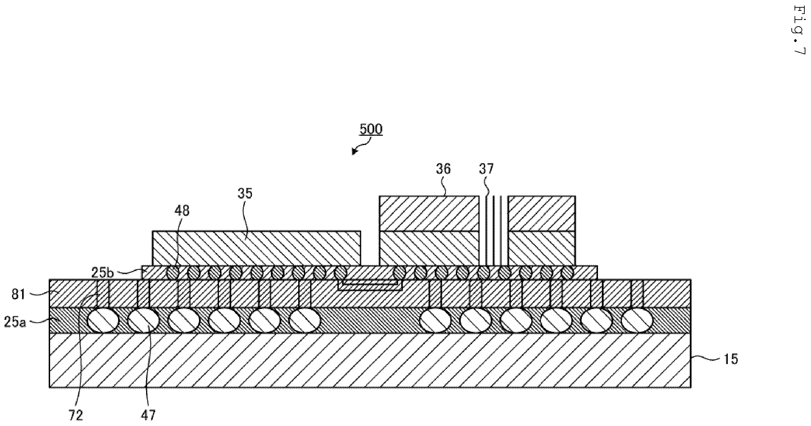

In another embodiment (sixth embodiment), as illustrated in FIG. 7, a semiconductor chip package 500 of the present invention includes a circuit board 15, a silicon interposer 81 that is bonded on the circuit board 15 via bumps 47, a first semiconductor chip 35 that is bonded on the silicon interposer 81 via bumps 48 and a laminate 36 having two or more semiconductor chips laminated in a vertical direction, and cured products of the underfill material 25a and 25b of the present invention, which fill the gap between the circuit board 15 and the silicon interposer 81 and the gap between the silicon interposer 81 and the first semiconductor chip 35 and the laminate 36. The laminate 36 consists of two or more semiconductor chip layers, in which the semiconductor chips are electrically connected through silicon pillars 37. The silicon interposer 81 may have via holes 72 formed from a viewpoint of electrically connecting the circuit board 15, the semiconductor chip 35, and the laminate 36. Because the underfill material of the present invention has a low viscosity, it is possible to increase the filling speed of the underfill material even in the package of the sixth embodiment. The cured products of the underfill materials 25a and 25b may be the same or different underfill material. The shape and the like of the circuit board and of the cured product of the underfill material used in the sixth embodiment are the same as those in the fifth embodiment.

### [Semiconductor Device]

The semiconductor device of the present invention has the semiconductor chip package of the present invention. The semiconductor device of the present invention may be produced using the semiconductor chip package of the present invention.

The semiconductor device may be various semiconductor devices used in electrical products (for example, a computer, a cellular phone, a digital camera, and a television) and vehicles (for example, a motorcycle, an automobile, a train, a marine ship, and an aircraft).

### [Examples]

Hereinafter, the present invention will be explained in detail by means of Examples. The present invention is not limited to Examples blow. In the following, "part" and "%" denoting quantities mean "part by mass" and "% by mass," respectively, unless otherwise specifically indicated. Temperature and pressure conditions are a room temperature (25°C) and an atmospheric pressure (1 atm), respectively, unless otherwise specifically indicated.

### <Example 1: Preparation of Underfill Material 1>

First, 9.0 parts of a mixed resin of a bisphenol A type epoxy resin and a bisphenol F type epoxy resin ("ZX-1059": manufactured by Nippon Steel Chemical & Material Co., Ltd., epoxy equivalent of about 160 to 170 g/eq.), 5.0 parts of methacrylic acid, and 6.0 parts of styrene were mixed and stirred. Next, 80 parts of Inorganic Filler 1 (silica having an average particle diameter of 8 um and a maximum particle diameter of 25 um) was added, and then, 0.4 parts of an organic base (2E4MZ: 2-ethyl-4-methylimidazole, manufactured by Shikoku Chemical Corp.) and 0.1 part of a radical polymerization catalyst ("Perhexyl O"; manufactured by NOF Corp.) were further added; then, the resulting mixture was uniformly dispersed using a high-speed rotary mixer to prepare Underfill Material 1.

### <Examples 2 to 18 and Comparative Example 1: Preparation of Underfill Materials 2 to 19>

In Example 1, the components were blended in the proportions described in the table below; then, from this a resin varnish was prepared using a high-speed rotary mixer. Underfill Materials 2 to 19 each were prepared in the same manner as in Example 1 except for the above items.

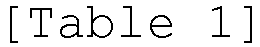

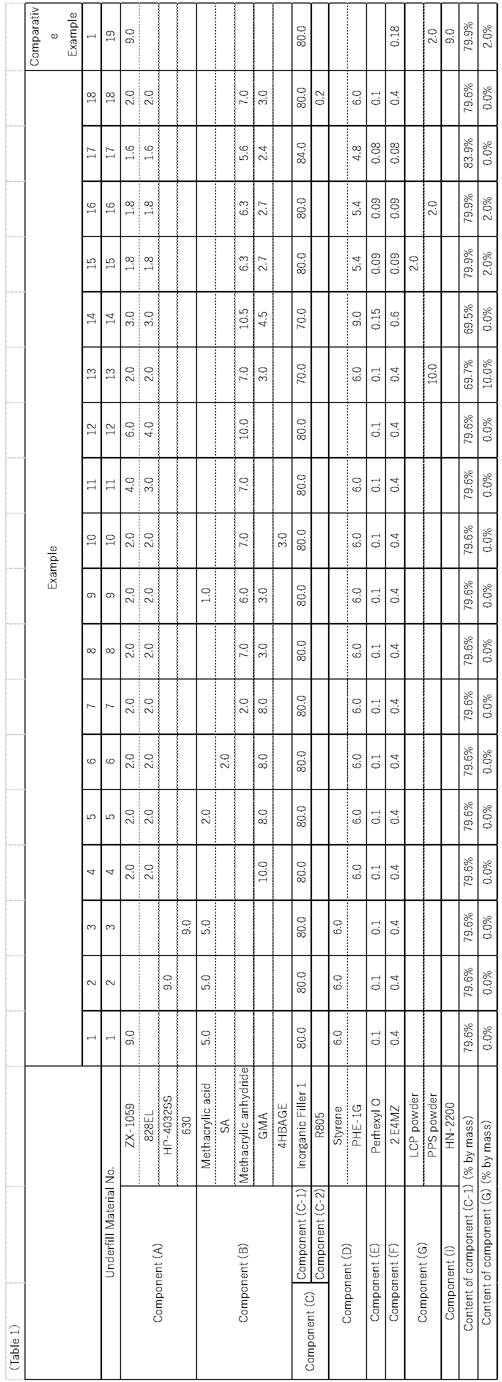

Abbreviations in the table are as follows. Here, note that the viscosity of each material was measured at a temperature of 25±2°C using an oscillating viscometer ("VM-10A-L": manufactured by Sekonic Corp.).
Component (A)
   ·ZX-1059: Mixture of bisphenol A type epoxy and bisphenol F type epoxy resin; manufactured by Nippon Steel Chemical & Material Co., Ltd., epoxy equivalent of 160 to 170 g/eq.
   ·828EL: Bisphenol A type epoxy resin; manufactured by Mitsubishi Chemical Corp., epoxy equivalent of 184 to 194 g/eq.
   ·HP-4032SS: Naphthalene type epoxy resin; manufactured by DIC Corp., epoxy equivalent of 136 to 148 g/eq.
   ·630: Glycidylamine type epoxy resin manufactured by Mitsubishi Chemical Corp., epoxy equivalent of 90 to 105 g/eq.
Component (B)
   ·Methacrylic acid: Manufactured by Tokyo Chemical Industry Co., Ltd., carboxyl equivalent of 86 g/eq., and viscosity of 1.3 mPa·s.
   ·SA: Manufactured by Shin-Nakamura Chemical Co., Ltd., carboxyl equivalent of 230 g/eq., and viscosity of 157 mPa·s.
   ·Methacrylic anhydride: Manufactured by Tokyo Chemical Industry Co., Ltd., acid anhydride equivalent of 154 g/eq.
   ·GMA: Glycidyl methacrylate, manufactured by Mitsubishi Gas Chemical Co., Ltd., epoxy equivalent of 142 g/eq., and viscosity of 2.0 mPa·s.
   ·4HBAGE: 4-Hydroxybutyl acrylate glycidyl ether, manufactured by Mitsubishi Chemical Corp., epoxy equivalent of 200 g/eq. and viscosity of 7.2 mPa·s.
Component (C)
   ·Inorganic Filler 1: Silica having an average particle diameter of 8 µm and a maximum particle diameter of 25 µm.
   ·R805: Silica having an average particle diameter of 12 nm, modified with octylsilane, manufactured by Nippon Aerosil Co., Ltd.
Component (D)
   ·Styrene: Manufactured by Tokyo Chemical Industry Co., Ltd., viscosity 0.7 mPa·s.
   ·PHE-1G: Phenoxyethylene glycol methacrylate, manufactured by Shin-Nakamura Chemical Co., Ltd., viscosity of 7.0 mPa·s.
Component (E)
   ·Perhexyl O: Radical polymerization catalyst, manufactured by NOF Corp.
Component (F)
   ·2E4MZ: Organic base, 2-ethyl-4-methylimidazole, manufactured by Shikoku Chemical Corp.
Component (G)
   ·LCP powder: Average particle diameter of 10 µm.
   ·PPS powder: Average particle diameter of 10 um.
Component (H)
   ·HN-2200: 3 or 4-Methyl-1,2,3,6-tetrahydrophthalic anhydride, manufactured by Showa Denko Materials Co., Ltd., acid anhydride equivalent of 166 g/eq.
   Content of component (C-1): Content of the component (C-1) relative to 100% by mass of the components in the underfill material.
   Content of component (G): Content of the component (G) relative to 100% by mass of the components in the underfill material.

### <Measurement of Viscosity>

Viscosity was measured using a viscosity and viscoelasticity measuring instrument (HAAKE Rheo Stress 6000 (manufactured by Thermo Fisher Scientific, Inc.)) at 40°C and 20 rpm, and this was evaluated in accordance with the following criteria.
O: Viscosity is less than 700 mPa·s.
Δ: Viscosity is 700 mPa·s or more and 2000 mPa·s or less.
X: Viscosity is more than 2000 mPa·s.

### <Preparation of Cured Product>

A casting plate was prepared by sandwiching a silicon tube between aluminum sheets coated with a mold release agent as a spacer so as to give a thickness of 1 mm. Each of Underfill Materials 1 to 19 was charged by means of a syringe and cured at 100°C for 5 hours to obtain a cured product.

### <Measurement of Glass Transition Temperature and Elastic Modulus>

The glass transition temperature (Tg) and elastic modulus at 250°C of each of the obtained cured products were measured under tensile conditions (strain amplitude of 10 µm, minimum tension of 0 mN, tension gain of 1.5, initial force amplitude of 10 mN, 1 Hz) using a viscoelasticity measurement instrument (DMA7100; manufactured by Hitachi, Ltd.) and evaluated in accordance with the following criteria.
⊚: Tg is 180°C or higher.
O: Tg is 160°C or higher and lower than 180°C.
Δ: Tg is 140°C or higher and lower than 160°C.
X: Tg is lower than 140°C.
O: Elastic modulus is 1.0 GPa or more.
X: Elastic modulus is less than 1.0 Pa.

### <Measurement of Cure Shrinkage>

The density of the underfill material before curing was measured using a dry automatic densitometer ("Accupic II": manufactured by Shimadzu Corp.). The density of the cured product was determined by the Archimedes method using a precision balance (XS225DUV: manufactured by Mettler Toledo, Inc.). The cure shrinkage was calculated from the respective densities obtained using the following formula and evaluated in accordance with the following criteria. Cure shrinkage = (post-cure density - pre-cure density)/ post-cure density × 100
O: Cure shrinkage is 1.0% or more
X: Cure shrinkage is less than 1.0%.

### <Measurement of Average Coefficient of Thermal Expansion (CTE)>

The cured product was cut into a test specimen with the size of 0.8 mm wide and 15 mm long, and the thermomechanical analysis was carried out using a thermomechanical analyzer (TMA7100, manufactured by Hitachi High-Tech Corp.) by the tensile loading method. After mounting the test specimen to the aforementioned apparatus, a load of 1 g was applied and the temperature was raised at the rate of 5°C/min to carry out the measurement twice consecutively. The average coefficient of thermal expansion (CTEα2: ppm) from Tg+40°C to 260°C in the second measurement was calculated and evaluated using the following evaluation criteria.
O: The average coefficient of thermal expansion is less than 50ppm.
Δ: The average coefficient of thermal expansion is 50 ppm or more and less than 100 ppm.
X: The average coefficient of thermal expansion is 100 ppm or more.

### <Volatility Measurement>

Each of Underfill Materials 1 to 19 was weighed (1 g) into an aluminum cup using a precision balance (XS225DUV: manufactured by Mettler Toledo, Inc.); then, this was heated on a hot plate heated at 40°C for 1 hour. The weight of the sample after heating was measured with the above precision balance, and volatility was evaluated by the ratio of the weight loss.
O: Weight loss is less than 4%.
Δ: Weight loss is 4% or more and less than 10%.
X: Weight loss is 10% or more.

### <Filling Test>

A 100-pm thickness thermosetting film (GX-92: manufactured by Ajinomoto Fine-Techno, Inc.) was attached to a glass plate to serve as a spacer with 1 cm wide and 100 µm high. The thermosetting film was covered with a glass plate on its surface opposite to the side that is in contact with the glass plate, which was then followed by curing the thermosetting film to obtain a test module having a gap of 100 um. The test module was placed on a hot plate heated at 40°C and Underfill Materials 1 to 18 each were dropped by means of a syringe; then, the progressing length (mm) per one minute was measured, and this was evaluated in accordance with the criteria below. In Underfill Material 19, because of a high viscosity, it was not possible to measure the progressing length per one minute.
O: Filling speed is 5 mm/min or more.
X: Filling speed is less than 5 mm/min

A silicon wafer was cut into the size of 3 cm × 3 cm: 900 mm²; and a thermosetting film (GX-92, Ajinomoto Fine-Techno, Inc.) with the size of 2 mm × 2 mm was attached to the four corners to serve as a spacer with a height of 100 um. The thermosetting film was covered with a glass plate on its surface opposite to the side that is in contact with the glass plate, which was then followed by curing the thermosetting film to obtain a test module having a gap of 100 um. The test module was placed on a hot plate heated at 40°C, and Underfill Materials 1 to 15 each were dropped onto one side of the module by means of a syringe; and then, the time required to complete the filling (filling completion time) was measured and evaluated in accordance with the criteria below. In Underfill Material 19, because of a high viscosity, it was not possible to fill the gap with Underfill Material 19.
O: Filling completion time is less than 120 minutes.
X: Filling completion time is 120 minutes or more.

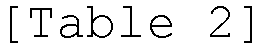

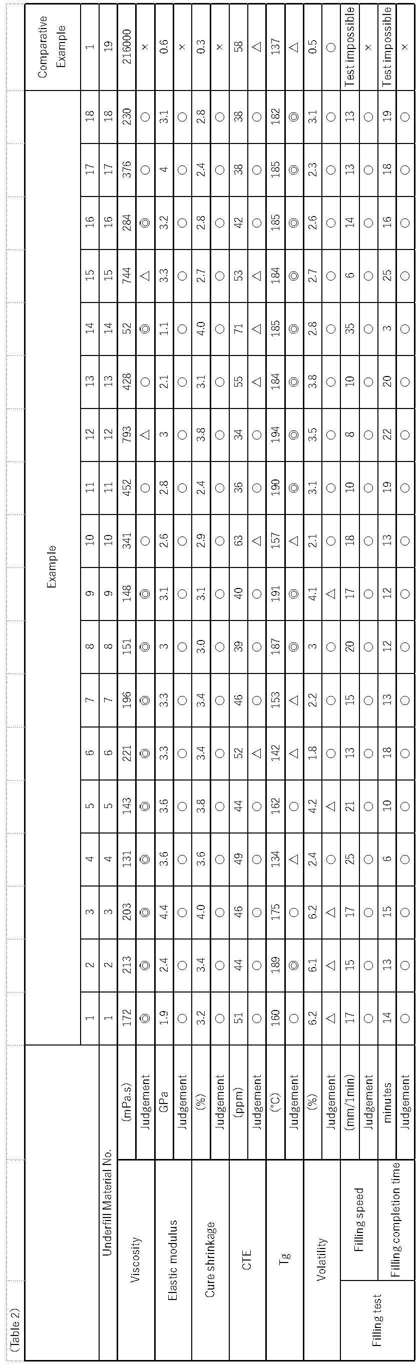

In Examples 1 to 18, it was confirmed that even when the components (D) to (G) were not included, more or less the same results as in Examples above were resulted.

### Reference Signs List

1, 100, 200, 300, 400, 500 Semiconductor chip package
10, 11, 12, 13, 14, 15 Circuit board
20, 21, 22, 23a, 23b, 24a, 24b, 25a, 25b Cured product of underfill material
30, 31, 32, 33, 34, 35 Semiconductor chip
36 Laminate
37 Through silicon pillar
41, 42, 43, 44, 45, 46, 47, 48, 49 Bumps
51 Encapsulating layer
61 Rewiring layer
71, 72 Via hole
80, 81 Silicon interposer
S1 Projected area of semiconductor chip
S2 Projected area of cured product of underfill material

## Claims

1. An underfill material comprising:
(A) an epoxy resin having two or more epoxy groups per one molecule thereof,
(B) a compound having a functional group that is capable of reacting with the epoxy group of the component (A) and an ethylenic unsaturated group, and
(C) an inorganic filler.

2. The underfill material according to claim 1, further comprising (D) a compound having an ethylenic unsaturated group not containing a functional group capable of reacting with the component (A).

3. The underfill material according to claim 2, wherein a content of the component (D) is 10% by mass or more to 70% by mass or less relative to 100% by mass of resin components in the underfill material.

4. The underfill material according to claim 1, wherein a content of the component (C) is 60% by mass or more relative to 100% by mass of components in the underfill material.

5. The underfill material according to claim 1, wherein a viscosity of the underfill material at 40°C is 2000 mPa·s or less.

6. The underfill material according to claim 1, wherein a molar ratio of all epoxy groups in the component (A) to all functional groups in the component (B) (all epoxy groups in the component (A) : all functional groups in the component (B)) is in the range of 30:70 to 80:20.

7. The underfill material according to claim 1, wherein the functional group of the component (B) that is capable of reacting with the epoxy group of the component (A) is one or more groups selected from an epoxy group, an acid anhydride group, and a carboxyl group.

8. The underfill material according to claim 1, wherein the component (B) comprises a compound having one or more epoxy groups and one or more ethylenic unsaturated groups in one molecule thereof.

9. The underfill material according to claim 1, wherein the component (B) comprises a glycidyl (meth)acrylate.

10. The underfill material according to claim 1, wherein the underfill material further comprises (E) a radical polymerization catalyst.

11. The underfill material according to claim 1, wherein the underfill material further comprises (F) an organic base.

12. The underfill material according to claim 1, wherein the underfill material further comprises (G) an organic filler.

13. The underfill material according to claim 1, wherein an average particle diameter of the component (C) is 15 um or less.

14. The underfill material according to claim 1, wherein an elastic modulus at 250°C of a cured product obtained by curing the underfill material is 1.0 GPa or more.

15. The underfill material according to claim 1, wherein a cure shrinkage of a cured product obtained by curing the underfill material is 1% or more.

16. The underfill material according to claim 1, wherein the underfill material is used to fill a gap between a circuit board and a semiconductor chip.

17. The underfill material according to claim 1, wherein the underfill material is used to fill a gap between a semiconductor chip and a rewiring layer.

18. The underfill material according to claim 1, wherein the underfill material is used to fill a gap between a circuit board and a rewiring layer.

19. The underfill material according to claim 17, wherein the rewiring layer comprises polyimide.

20. The underfill material according to claim 1, wherein the underfill material is for a semiconductor device of a multiple die package.

21. The underfill material according to claim 1, wherein the underfill material is for a semiconductor device of a semiconductor chip package having an area of 900 mm² or more.

22. The underfill material according to claim 1, wherein the underfill material is for a semiconductor device comprising a fan-out type package.

23. The underfill material according to claim 1, wherein the underfill material is for a semiconductor device comprising a semiconductor package comprising a silicon interposer.

24. The underfill material according to claim 1, wherein the underfill material is for a semiconductor device comprising a laminate having two or more semiconductor chips laminated in a vertical direction through a through silicon via.

25. The underfill material according to claim 16, wherein the gap is 200 um or less.

26. The underfill material according to claim 16, wherein the gap is 100 um or less.

27. The underfill material according to claim 1, wherein the underfill material comprises at least one or more of the component (D) having a viscosity of 50 mPa·s or less at 25°C.

28. The underfill material according to claim 1, wherein the underfill material comprises at least one or more of the component (B) having a viscosity of 50 mPa·s or less at 25°C.

29. The underfill material according to claim 1, wherein the underfill material is used in a post-application method.

30. A semiconductor chip package comprising a cured product of the underfill material according to any one of claims 1 to 29.

31. A semiconductor chip package comprising a circuit board, a semiconductor chip that is bonded and mounted to the circuit board, and a cured product of the underfill material according to any one of claims 1 to 29 that fills a gap between the circuit board and the semiconductor chip.

32. The semiconductor chip package according to claim 30, wherein (S2/S1) × 100 is 120% or less, provided that S1 represents a projected area of a surface of a semiconductor chip and S2 represents a projected area of the cured product of the underfill material.

33. The semiconductor chip package according to claim 30, wherein (S2/S1) × 100 is 110% or less, provided that S1 represents a projected area of a surface of a semiconductor chip and S2 represents a projected area of the cured product of the underfill material.

34. The semiconductor chip package according to claim 30, wherein (S2/S1) × 100 is 1050 or less, provided that S1 represents a projected area of a surface of a semiconductor chip and S2 represents a projected area of the cured product of the underfill material.

35. The semiconductor chip package according to claim 30, wherein a cross-sectional shape of the cured product of the underfill material becomes smaller from a semiconductor chip toward a center of the cured product and larger from the center of the cured product toward the circuit board.

36. A method for producing a semiconductor chip package, the method comprising a step of filling a gap between a circuit board and a semiconductor chip or an interposer with the underfill material according to any one of claims 1 to 29, wherein
an area of the semiconductor chip package or of the interposer is 900 mm² or more, the gap is 600 um or less, and a filling completion time of the underfill material is less than 120 minutes.

37. A semiconductor device comprising the semiconductor chip package according to claim 30.

38. A cured product of the underfill material according to any one of claims 1 to 29.
